# EUROPEAN PATENT SPECIFICATION

(11) **EP 3 208 469 B1**
(45) Date of publication and mention of the grant of the patent: **08.11.2023**
(21) Application number: 16806788.2
(22) Date of filing: 06.06.2016
(51) Int. Cl.: F04D 27/00, F24F 11/00, H04M 1/725

(54) **METHOD AND DEVICE FOR ADJUSTING OPERATING DATA**
VERFAHREN UND VORRICHTUNG ZUR ANPASSUNG VON BETRIEBSDATEN
PROCÉDÉ ET APPAREIL DE RÉGULATION DE DONNÉES DE FONCTIONNEMENT

(30) Priority: 12.06.2015 CN 201510325484
(43) Date of publication of application: 23.08.2017
(73) Proprietor: Xiaomi Inc., Beijing 100085 (CN)
(72) Inventor: SU, Jun, Beijing 100085 (CN); WANG, Mengnan, Beijing 100085 (CN); XIA, Yongfeng, Beijing 100085 (CN); WANG, Yi, Beijing 100085 (CN)
(74) Representative: Cabinet Beau de Loménie
(86) International application number: PCT/CN2016/084960
(87) International publication number: WO 2016/197890

(56) References cited:
- CN-A- 103 032 935
- CN-A- 104 236 026
- CN-A- 105 090 081
- JP-A- H04 116 325
- JP-A- 2003 240 317
- JP-A- 2005 147 436
- US-A1- 2010 121 494
- US-A1- 2012 101 647
- US-A1- 2014 044 558
- US-A1- 2014 227 085

## Description

### TECHNICAL FIELD

The present invention generally relates to information processing technologies, and more particularly, to a method and device for adjusting operation parameters of an air outlet device.

### BACKGROUND

Recently, living standards have been improved so much, and air outlet devices, as fairly common home appliance, have been widely used by more and more users. During usage, it is needed to adjust operation parameters of the air outlet devices. For example, the air outlet devices may include fans, air conditioners, air-coolers, or the like, and the operation parameters may include the air speed and the angle indicating air flow direction of the air outlet devices. One of existing methods for adjusting the operation parameters is to periodically adjust the operation parameters of the air outlet devices by a preset controller/timer so that the air outlet devices can output air periodically in accordance with the operation parameters. For example, the preset controller/timer of an air outlet device is set as that the air outlet device runs at a low speed when it is started, runs at a high speed after five minutes, at a low speed after another five minutes, and then stops. According to the settings of the controller/timer, the operation parameters of the air outlet device can be periodically adjusted, and then the air outlet device can cause air to be out based on the above approach.

US 2012/0101647 discloses a method and device for use in connection with a bathing system that comprises a heating module and a filtration system. The method comprises receiving an input conveying a desire to operate the heating module and/or the filtration system in accordance with an energy savings mode, and causing the heating module and/or the filtration system to acquire an actuated state and a non-actuated state on a basis of a usage profile associated with the energy savings mode.

CN 103 032 935 A appears to disclose an air conditioner remote control unit capable of controlling settings like wind speed and wind direction of an air conditioner and of enabling control of a set temperature according to a prediction of outside temperature.

### SUMMARY

In order to address problems in the prior art, the present invention provides a method and a device for adjusting operation parameters of an air outlet device. The invention is set out in the appended set of claims.

According to a first aspect of embodiments of the present invention, there is provided a method for adjusting operation parameters of an air outlet device according to claim 1.

The present disclosure further provides a method for adjusting operation parameters, which is not covered by the subject-matters of the claims. The method includes:
when detecting an instruction for adjusting operation parameters, displaying an operation parameters adjustment interface which is configured to adjust an air speed and an angle indicating air flow direction of an air outlet device; and
according to an operation on the operation parameters adjustment interface performed by a user, obtaining first operation parameters to enable the air outlet device to output air according to the first operation parameters.

In a first possible implementation, obtaining the first operation parameters according to the operation on the operation parameters adjustment interface performed by the user, includes:
displaying on the operation parameters adjustment interface coordinate axes of the operation parameters, among which a horizontal axis represents the time and a vertical axis represents the operation parameters, wherein a first curve is plotted in a coordinate system formed by the coordinate axes of the operation parameters, and the first curve indicates changes of the operation parameters in a historical time period;
when detecting a sliding operation on the first curve by the user, modifying a trajectory of the first curve according to the sliding operation; and
according to the modified trajectory of the first curve, obtaining the first operation parameters.

In a second possible implementation, before displaying the coordinate axes of the operation parameters on the operation parameters adjustment interface, the method further includes:
obtaining operation parameters of the air outlet device in the historical time period; and
according to the operation parameters in the historical time period, plotting the first curve indicating changes of the operation parameters in the coordinate system formed by the coordinate axes of the operation parameters.

In a third possible implementation, obtaining first operation parameters according to the operation on the operation parameters adjustment interface performed by the user, includes:
displaying on the operation parameters adjustment interface coordinate axes of the operation parameters, among which a horizontal axis represents the time and a vertical axis represents the operation parameters;
when detecting a sliding operation in a coordinate system formed by the coordinate axes of the operation parameters performed by the user, plotting in the coordinate system a second curve which indicates changes of the operation parameters in a future time period according to the sliding operation; and
according to a trajectory of the second curve, obtaining the first operation parameters.

In a fourth possible implementation, obtaining first operation parameters according to the operation on the operation parameters adjustment interface performed by the user, includes:
obtaining second operation parameters indicating current operation status of the air outlet device;
displaying the second operation parameters on the operation parameters adjustment interface; and
when detecting an operation for modifying the second operation parameters by the user, obtaining the first operation parameters which is resulted from modification of the second operation parameters.

According to a second aspect of embodiments of the present invention, there is provided a device for adjusting operation parameters of an air outlet device according to claim 2.

The present disclosure further provides a device for adjusting operation parameters, which is not covered by the subject-matters of the claims. The device includes:
a display module configured to, when an instruction for adjusting operation parameters is detected, display an operation parameters adjustment interface which is configured to adjust an air speed and an angle of air flow direction of an air outlet device; and
an obtaining module configured to, according to an operation on the operation parameters adjustment interface performed by a user, obtain first operation parameters to enable the air outlet device to output air according to the first operation parameters.

In a first possible implementation, the obtaining module includes:
a display unit configured to display on the operation parameters adjustment interface coordinate axes of the operation parameters, among which a horizontal axis represents the time and a vertical axis represents the operation parameters, wherein a first curve is plotted in a coordinate system formed by the coordinate axes of the operation parameters, and the first curve indicates changes of the operation parameters in a historical time period;
a modification unit configured to, when a sliding operation on the first curve by the user is detected, modify a trajectory of the first curve according to the sliding operation; and
an obtaining unit configured to, according to the modified trajectory of the first curve, obtain the first operation parameters.

In a second possible implementation, the obtaining module further includes:
an obtaining unit configured to obtain operation parameters of the air outlet device in the historical time period; and
a plotting unit configured to, according to the operation parameters in the historical time period, plot the first curve indicating changes of the operation parameters in the coordinate system formed by the coordinate axes of the operation parameters.

In a third possible implementation, the obtaining module is configured to: display on the operation parameters adjustment interface coordinate axes of the operation parameters, among which a horizontal axis represents the time and a vertical axis represents the operation parameters; when a sliding operation in a coordinate system formed by the coordinate axes of the operation parameters performed by the user is detected, plot in the coordinate system a second curve which indicates changes of the operation parameters in a future time period according to the sliding operation; and according to a trajectory of the second curve, obtain the first operation parameters.

In a fourth possible implementation, the obtaining module is configured to: obtain second operation parameters indicating current operation status of the air outlet device; display the second operation parameters on the operation parameters adjustment interface; and when an operation for modifying the second operation parameters by the user is detected, obtain the first operation parameters which is resulted from modification of the second operation parameters.

The present disclosure further provides a terminal, which is not covered by the subject-matters of the claims. The terminal includes:
a processor; and
a memory for storing instructions executable by the processor;
wherein the processor is configured to:
   when detect an instruction for adjusting operation parameters, display an operation parameters adjustment interface which is configured to adjust an air speed and an angle indicating air flow direction of an air outlet device; and
   according to an operation on the operation parameters adjustment interface performed by a user, obtain first operation parameters to enable the air outlet device to output air according to the first operation parameters.

Technical solutions provided by embodiments of the present invention can have the following advantageous effects.

By displaying a theme pack list on an application interface, when detecting a selection instruction on the theme pack list by a user, a theme pack which is selected by the user is determined according to the selection instruction; and the operation parameters in the selected theme pack is obtained to enable an air outlet device to output air according to the operation parameters. Users can select theme packs of different kinds to make the air outlet device adjust the operation parameters according to the theme packs of different kinds, and then the air outlet device can output air following corresponding air outlet manners. Thus, there are provided diversified air outlet manners, and the air outlet device can output air according to users demands. Consequently, better air outlet effects can be achieved when the operation parameters is adjusted.

It is to be understood that both the foregoing general description and the following detailed description are exemplary and explanatory only and are not restrictive of the invention, as claimed.

### BRIEF DESCRIPTION OF THE DRAWINGS

The accompanying drawings, which are incorporated in and constitute a part of this specification, illustrate embodiments consistent with the invention and, together with the description, serve to explain the principles of the invention.

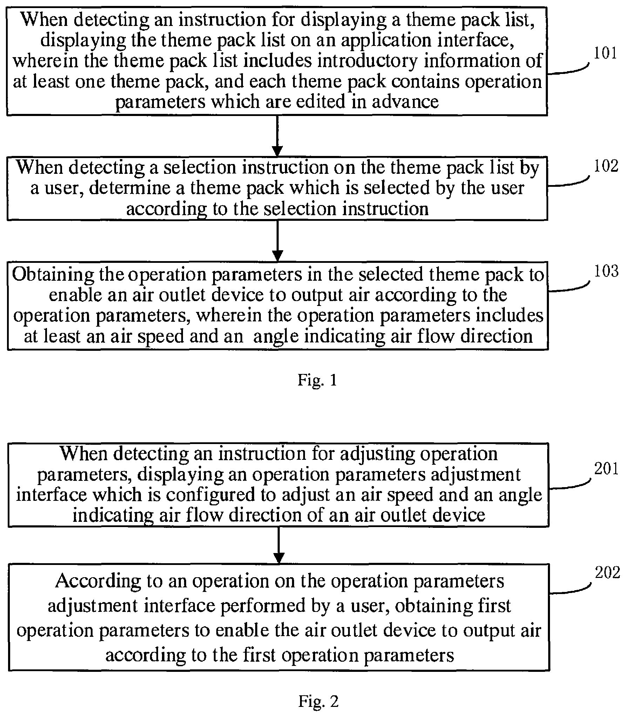

None of the flowcharts shown in the figures completely covers the invention as claimed. The claimed invention consists of at least the flow charts of figures 1, 2 and 3, complemented with further steps as specified in the claims.

Only the claims determine the true scope of protection of the patent.
Fig. 1 is a flowchart showing a method for adjusting operation parameters according to an exemplary embodiment.
Fig. 2 is a flowchart showing a method for adjusting operation parameters according to an exemplary embodiment.
Fig. 3 is a flowchart showing a method for adjusting operation parameters according to an exemplary embodiment.
Fig. 4 schematically shows a theme pack list according to an exemplary embodiment.
Fig. 5 schematically shows operation parameters in a theme pack according to an exemplary embodiment.
Fig. 6 is a flowchart showing a method for adjusting operation parameters according to an exemplary embodiment.
Fig. 7 schematically shows an operation parameters adjustment interface according to an exemplary embodiment.
Fig. 8 schematically shows an operation parameters adjustment interface according to an exemplary embodiment.
Fig. 9 schematically shows an operation parameters adjustment interface according to an exemplary embodiment.
Fig. 10 is a block diagram showing a device for adjusting operation parameters according to an exemplary embodiment.
Fig. 11 is a block diagram showing a device for adjusting operation parameters according to an exemplary embodiment.
Fig. 12 is a block diagram showing a device for adjusting operation parameters according to an exemplary embodiment.
Fig. 13 is a block diagram showing an adjustment module according to an exemplary embodiment.
Fig. 14 is a block diagram showing a device for adjusting operation parameters according to an exemplary embodiment.
Fig. 15 is a block diagram showing an obtaining module according to an exemplary embodiment.
Fig. 16 is a block diagram showing an obtaining module according to an exemplary embodiment.
Fig. 17 is a block diagram showing a terminal according to an exemplary embodiment.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of devices and methods consistent with aspects related to the invention as recited in the appended claims.

Fig. 1 is a flowchart showing a method for adjusting operation parameters according to an exemplary embodiment. The method for adjusting operation parameters is performed by a terminal. As shown in Fig. 1, the method for adjusting operation parameters can include the following steps.

In step 101, when an instruction for displaying a theme pack list is detected, the theme pack list is displayed on an application interface. The theme pack list includes introductory information of at least one theme pack, and each theme pack contains operation parameters which are edited in advance.

In step 102, when a selection instruction on the theme pack list by a user is detected, a theme pack which is selected by the user is determined according to the selection instruction.

In step 103, the operation parameters in the selected theme pack is obtained to enable an air outlet device to output air according to the operation parameters. The operation parameters include at least an air speed and an angle indicating air flow direction.

In the method provided by embodiments of the present invention, by displaying a theme pack list on an application interface, when detecting a selection instruction on the theme pack list by a user, a theme pack which is selected by the user is determined according to the selection instruction; and the operation parameters in the selected theme pack is obtained to enable an air outlet device to output air according to the operation parameters. Users can select theme packs of different kinds to make the air outlet device adjust the operation parameters according to the theme packs of different kinds, and then the air outlet device can output air following corresponding air outlet manners. Thus, there are provided diversified air outlet manners, and the air outlet device can output air according to users' demands. Consequently, better air outlet effects can be achieved when the operation parameters is adjusted.

Before displaying the theme pack list on the application interface, the method further includes:
downloading theme packs of different kinds and corresponding introductory information; and
generating the theme pack list according to the introductory information of respective downloaded theme packs.

After determining the theme pack which is selected by the user according to the selection instruction when detecting the selection instruction on the theme pack list by the user, the method further includes:
obtaining region information corresponding to the theme pack selected by the user; and
according to the region information, adjusting an auxiliary device of the air outlet device, wherein the auxiliary device includes at least a temperature adjustment device.

Adjusting the auxiliary device according to the region information, includes:
obtaining current weather information of a region corresponding to the region information, wherein the weather information includes at least a temperature value; and
according to the weather information, adjusting the auxiliary device.

Adjusting the auxiliary device of the air outlet device according to the region information, includes:
when the auxiliary device is the temperature adjustment device, sending the temperature value in the weather information to the temperature adjustment device to enable the temperature adjustment device to adjust temperatures based on the temperature value; and
when the auxiliary device is an oxygen generation device, sending an oxygen concentration value in the weather information to the oxygen generation device to enable the oxygen generation device to adjust oxygen concentrations based on the oxygen concentration value.

Fig. 2 is a flowchart showing a method for adjusting operation parameters according to an example of the present disclosure, which is not covered by the subject-matters of the claims. The method for adjusting operation parameters is performed by a terminal. As shown in Fig. 2, the method for adjusting operation parameters can include the following steps.

In step 201, when an instruction for adjusting operation parameters is detected, an operation parameters adjustment interface which is configured to adjust an air speed and an angle indicating air flow direction of an air outlet device is displayed.

In step 202, according to an operation on the operation parameters adjustment interface performed by a user, first operation parameters is obtained to enable the air outlet device to output air according to the first operation parameters.

In the method above, by displaying an operation parameters adjustment interface, according to an operation on the operation parameters adjustment interface performed by a user, first operation parameters is obtained to enable the air outlet device to output air according to the first operation parameters. Users can adjust operation parameters on the operation parameters adjustment interface, and thus according to the adjusted operation parameters, the air outlet device can output air following the corresponding air outlet manners. Thus, there are provided diversified air outlet manners, and the air outlet device can output air according to users' demands. Consequently, better air outlet effects can be achieved when the operation parameters is adjusted.

As an example, obtaining the first operation parameters according to the operation on the operation parameters adjustment interface performed by the user, includes:
displaying on the operation parameters adjustment interface coordinate axes of the operation parameters, among which a horizontal axis represents the time and a vertical axis represents the operation parameters, wherein a first curve is plotted in a coordinate system formed by the coordinate axes of the operation parameters, and the first curve indicates changes of the operation parameters in a historical time period;
when detecting a sliding operation on the first curve by the user, modifying a trajectory of the first curve according to the sliding operation; and
according to the modified trajectory of the first curve, obtaining the first operation parameters.

As an example, before displaying the coordinate axes of the operation parameters on the operation parameters adjustment interface, the method further includes:
obtaining operation parameters of the air outlet device in the historical time period; and
according to the operation parameters in the historical time period, plotting the first curve indicating changes of the operation parameters in the coordinate system formed by the coordinate axes of the operation parameters.

As an example, obtaining first operation parameters according to the operation on the operation parameters adjustment interface performed by the user, includes:
displaying on the operation parameters adjustment interface coordinate axes of the operation parameters, among which a horizontal axis represents the time and a vertical axis represents the operation parameters;
when detecting a sliding operation in a coordinate system formed by the coordinate axes of the operation parameters performed by the user, plotting in the coordinate system a second curve which indicates changes of the operation parameters in a future time period according to the sliding operation; and
according to a trajectory of the second curve, obtaining the first operation parameters.

As an example, obtaining first operation parameters according to the operation on the operation parameters adjustment interface performed by the user, includes:
obtaining second operation parameters indicating current operation status of the air outlet device;
displaying the second operation parameters on the operation parameters adjustment interface; and
when detecting an operation for modifying the second operation parameters by the user, obtaining the first operation parameters which is resulted from modification of the second operation parameters.

All of the above optional technical solutions can be combined in any way, and detailed descriptions are not provided herein.

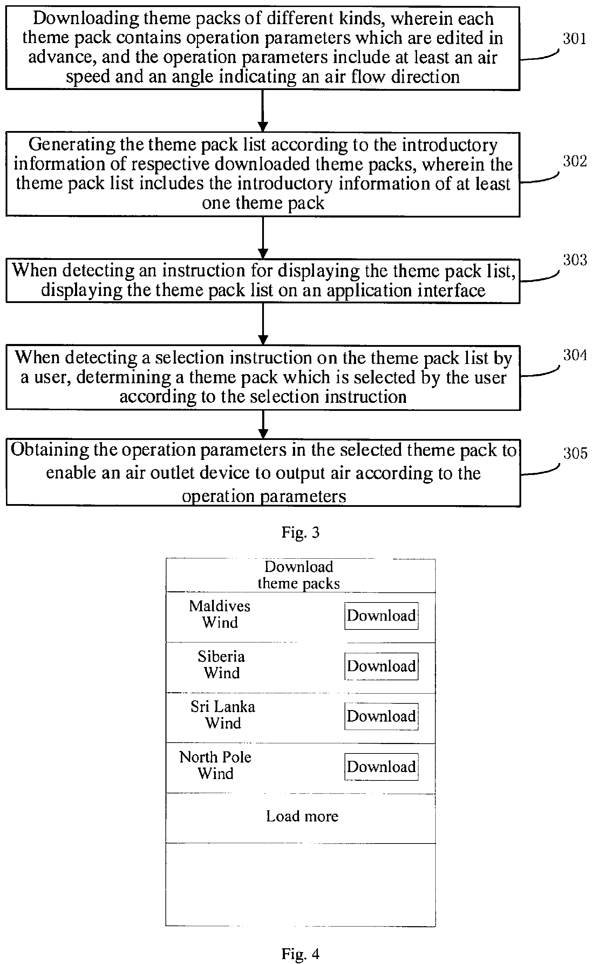

Fig. 3 is a flowchart showing a method for adjusting operation parameters according to an exemplary embodiment. As shown in Fig. 3, the method for adjusting operation parameters is performed by a terminal, and can include the following steps.

In step 301, theme packs of different kinds and corresponding introductory information are downloaded. Each of the theme packs includes operation parameters which are edited in advance, and the operation parameters include at least an air speed and an angle indicating air flow direction (or, the angle reflecting the air flow direction).

For example, the operation parameters can be the air speed, the angle indicating air flow direction of an air outlet device, and the like, and the present embodiment does not impose specific limitations on this. The theme packs may be classified according to climates in different regions, and the present embodiment does not impose specific limitations on the classification of the theme packs. For example, the theme packs may, according to climates in different regions, include a theme pack called "Maldives Wind", a theme pack called "Siberia Wind", a theme pack called "Sri Lanka Wind", a theme pack called "North Pole Wind", and the like. Different regions differ greatly in climate, and the air flows adapt to different regions can bring different experiences to users. Based on the above contents, the theme packs of different kinds can include relevant parameters regarding the air flow in different regions (i.e., the operation parameters which are edited in advance), the air outlet device can output air according to the operation parameters in the theme packs, i.e., simulating the air flow in different regions. Then, users can experience the air flow in varied regions even indoors.

Further, a preset application on the terminal which is related to the air outlet device can be used to automatically download the theme packs of different kinds and the introductory information. Alternatively, users can manually download the theme packs of different kinds and the introductory information using the preset application. The present embodiment does not impose specific limitations on the approach for downloading the theme packs of different kinds.

It shall be noted that the terminal can download the theme packs from a server side, and the theme packs stored in the server side can be uploaded by relevant operators or can be produced by users and then uploaded using the preset application. The present embodiment does not impose limitations on the sources of the theme packs at the server side. When a user produces and uploads the theme packs, he/she can produce different kinds of theme packs according to his/her own preferences, and upload the produced theme packs onto the server using the preset application. After receiving the theme packs uploaded by the terminal, the server can store the received theme packs. When other users log in to the preset application, the server can provide an online store for downloading the theme packs, and then other users can download the theme packs produced by the user from the online store. In this way, theme packs can be shared between different users.

In step 302, according to the introductory information of each of the downloaded theme packs, a theme pack list is generated. The theme pack list includes the introductory information of at least one theme pack.

Each item in the theme pack list can include the introduction information of each of the downloaded theme packs and the interface interaction elements for downloading each of the theme packs, and the present embodiment does not impose specific limitations on the contents included in the theme pack list. The theme pack list can include the introduction information of at least one theme pack, and users can download different theme packs by tapping the interface interaction elements of each of the theme packs, and the present embodiment does not impose specific limitations on this. For example, as shown in Fig. 4, the theme pack list can include the introductory information of three downloaded theme packs, and a download button is provided at the right side of each theme pack to enable users to download the theme pack by tapping.

In step 303, when an instruction for displaying the theme pack list is detected, the theme pack list is displayed on an application interface.

When a user needs to select a theme pack, he/she may input an instruction for displaying the theme pack list using the preset application. When the terminal detects the instruction for displaying the theme pack list, the terminal can display the theme pack list on the application interface.

In step 304, when a selection instruction on the theme pack list is detected, the theme pack selected by the user is determined according to the selection instruction.

After the theme pack list is displayed on the application interface, the user can select a theme pack on the theme pack list according to his/her requirements. The theme pack selected by the user in this step is mainly used for adjusting the air outlet manner of the air outlet device in subsequent steps. When simulating experiences about air flow in different regions, in addition to the touch senses resulted from different air outlet manners, other external senses such as visual and aural senses may be provided to the user. Accordingly, in addition to the air outlet device, other auxiliary devices may be provided to bring other senses to the user, so that the user can have better air blowing experiences.

In view of the above, after the theme pack selected by the user is determined according to the selection instruction when the selection instruction on the theme pack list by the user is detected, the present embodiment further provides a method for adjusting auxiliary devices, including but not limited to: obtaining region information corresponding to the theme pack selected by the user; and according to the region information, adjusting an auxiliary device of the air outlet device. The region information can include longitude and latitude coordinates information, and the present embodiment does not impose specific limitations on this. The auxiliary devices includes at least one temperature adjustment device, and can further include audio devices, video playing devices, and the like, and the present embodiment does not specific limitations on the types of the auxiliary devices. The above auxiliary devices can bring different experiences such as senses of warmth or coolness, visual or aural senses to the user, so that the user can have experiences about climates and environments in different regions.

When adjusting the auxiliary devices according to the region information, current weather information corresponding to the region indicated by the region information is obtained. Thus, the auxiliary devices is adjusted according to the weather information. The weather information includes at least one temperature value, and can further include kinds of the weather and the like, and the present embodiment does not impose specific limitations on the contents of the weather information.

There may be a lot of auxiliary devices. When adjusting the auxiliary devices according to the weather information, different auxiliary devices can correspond to different adjustment approaches. In particular, when the auxiliary device is a temperature adjustment device, the temperature value in the weather information is sent to the temperature adjustment device to enable the temperature adjustment device to adjust temperatures based on the temperature value; when the auxiliary device is an oxygen generation device, an oxygen concentration value in the weather information is sent to the oxygen generation device to enable the oxygen generation device to adjust oxygen concentrations based on the oxygen concentration value. In addition to the above adjustment approaches, other auxiliary devices may have corresponding adjustment approaches, and the present embodiment does not impose specific limitations on this.

For example, when the user selects the theme pack called "Maldives Wind", the terminal can obtain region information corresponding to the theme pack called "Maldives Wind", for example, the longitude and latitude coordinates information of Maldives. The terminal can search the current weather information of Maldives via networks according to the longitude and latitude coordinates information. For example, the weather information is the temperature value, the auxiliary device is a temperature adjustment device. Then, the temperature adjustment device can adjust the temperature according to the temperature value so as to adjust the indoor temperature into the local temperature of Maldives. Further, considering that Maldives is an archipelago country on the India Ocean, the video playing device as an auxiliary device can play the video about the beautiful beach, and the audio device as an auxiliary device can play the sound of the air flow, and the oxygen generation device can adjust the indoor oxygen concentration into the local oxygen concentration of Maldives. In this way, the user can have experiences as local style at Maldives.

In step 305, the operation parameters in the pack theme is obtained to make the air outlet device output air according to the operation parameters.

After obtaining the operation parameters in the theme pack, the terminal can send the operation parameters in the theme pack to the air outlet device. After receiving the operation parameters, the air outlet device can output air according to the operation parameters. The air outlet device can be provided with a Wireless Fidelity (WiFi) module to receive the operation parameters sent from the terminal, and the present embodiment does not impose specific limitations on this.

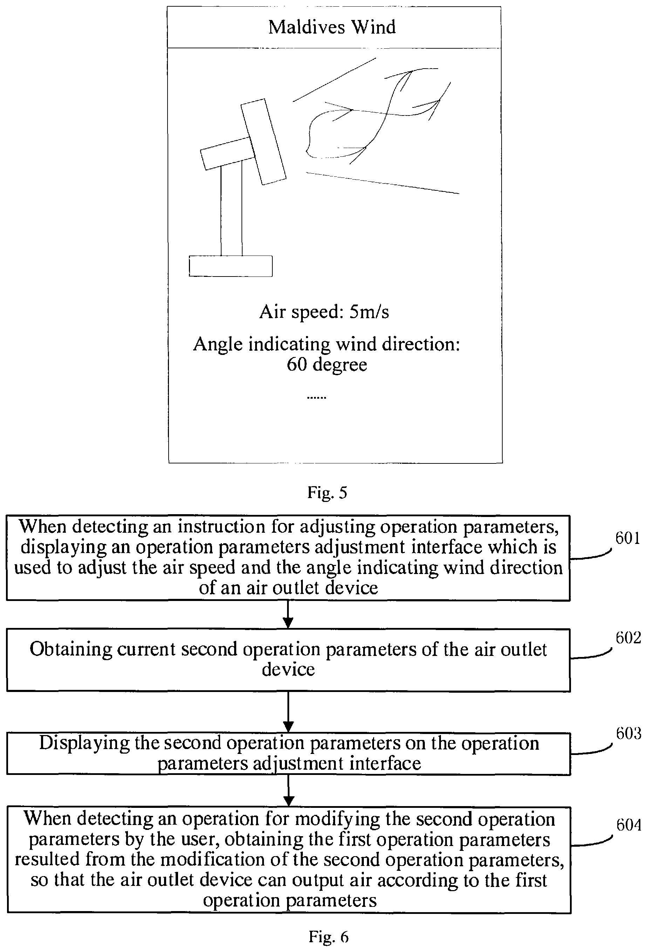

Further, after the air outlet device output air according to the operation parameters, in order to make the user know the current operation status of the air outlet device, the theme and corresponding operation parameters currently used by the air outlet device can be displayed on the application interface, and the present embodiment does not impose specific limitations on this. For example, as shown in Fig. 5, the operation parameters of the air outlet device under the theme called "Maldives Wind" is displayed on the application interface.

In the methods provided by embodiments of the present invention, by displaying a theme pack list on an application interface, when detecting a selection instruction on the theme pack list by a user, a theme pack which is selected by the user is determined according to the selection instruction; and the operation parameters in the selected theme pack is obtained to enable an air outlet device to output air according to the operation parameters. Users can select theme packs of different kinds to make the air outlet device adjust the operation parameters according to the theme packs of different kinds, and then the air outlet device can output air following corresponding air outlet manners. Thus, there are provided diversified air outlet manners, and the air outlet device can output air according to users' demands. Consequently, better air outlet effects can be achieved when the operation parameters is adjusted.

Further, in addition to enabling the air outlet device to output air according different air outlet manners, auxiliary devices are also used to bring different levels of sensual experiences to users, thereby improving user's air blowing experience.

Fig. 6 is a flowchart showing a method for adjusting operation parameters according to an example of the present disclosure, which is not covered by the subject-matters of the claims. As shown in Fig. 6, the method for adjusting operation parameters is performed by a terminal and can include the following steps.

In step 601, when an instruction for adjusting operation parameters is detected, an operation parameters adjustment interface is displayed. The operation parameters adjustment interface is used to adjust the air speed and the angle indicating air flow direction of an air outlet device.

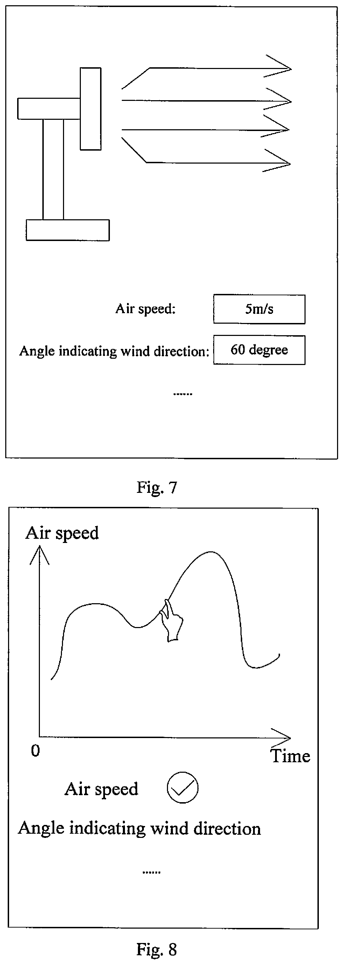

After a user opens an application related to the air outlet device, he/she can input an instruction for adjusting operation parameters. After detecting the instruction for adjusting operation parameters, the terminal can display an operation parameters adjustment interface. For example, the operation parameters adjustment interface can be found in Fig. 7, the operation parameters adjustment interface can include input boxes for inputting operation parameters.

In step 602, current second operation parameters (i.e., the operation parameters indicating the current status of the air outlet device) of the air outlet device is obtained.

The terminal can send an instruction for requesting operation parameters to the air outlet device. After receiving the instruction for requesting operation parameters from the terminal, the air outlet device can return the current second operation parameters, and then the terminal can obtain the current second operation parameters of the air outlet device. The second operation parameters can include the current air speed and the angle indicating air flow direction of the air outlet device, and the present disclosure does not impose specific limitations on this.

In step 603, the second operation parameters are displayed on the operation parameters adjustment interface.

After obtaining the second operation parameters, the second operation parameters can be displayed on the operation parameters adjustment interface. For example, as shown in Fig. 7, each input box displays the current operation parameters. As can be seen, the air speed is 5 m/s, and the angle indicating air flow direction is 60 degree.

In step 604, when detecting an operation for modifying the second operation parameters by the user, first operation parameters resulted from the modification of the second operation parameters is obtained, so that the air outlet device can output air according to the first operation parameters.

After displaying the second operation parameters on the operation parameters adjustment interface, the user can modify the second operation parameters on the operation parameters adjustment interface according to his/her own requirements. After detecting the operation for modifying the second operation parameters by the user, the first operation parameters resulted from the modification of the second operation parameters can be obtained. The terminal sends the first operation parameters to the air outlet device. After receiving the first operation parameters, the air outlet device outputs air according to the first operation parameters. The air outlet device can be provided with a WiFi module to receive the operation parameters sent from the terminal, and the present disclosure does not impose specific limitations on this.

It shall be noted that the above steps 602 to 604 are the procedure for obtaining the first operation parameters performed by the terminal according to the operations by the user on the operation parameters adjustment interface. In addition to modifying the current second operation parameters of the air outlet device by the user to obtain the first operation parameters, the present disclosure also provides the following two approaches for obtaining the first operation parameters.

The first approach can include: displaying on the operation parameters adjustment interface coordinate axes of the operation parameters, among which a horizontal axis represents the time and a vertical axis represents the operation parameters, wherein a first curve is plotted in a coordinate system formed by the coordinate axes of the operation parameters, and the first curve indicates changes of the operation parameters in a historical time period; when detecting a sliding operation on the first curve by the user, modifying a trajectory of the first curve according to the sliding operation; and according to the modified trajectory of the first curve, obtaining the first operation parameters.

The first curve represents the changes of the operation parameters in a historical time period, and thus in order to obtain the first curve, operation parameters of the air outlet device in the historical time period can be obtained before displaying the coordinates axes of the operation parameters on the operation parameters adjustment interface, and then according to the operation parameters in the historical time period, the first curve representing the changes of the operation parameters can be plotted in the coordinate system formed by the coordinate axes of the operation parameters. The length of the historical time period can be set according to requirements, for example, 30 minutes, 1 hour, or the like, and the present disclosure does not impose specific limitations on this. Further, because the operation parameters can be of different kinds, the coordinate axes of the operation parameters can vary, and the terminal can plot first curves corresponding to respective kinds of operation parameters in the coordinate systems formed by respective kinds of coordinate axes.

It shall be noted that the operation parameters can be of different kinds, before displaying the coordinate axes of the operation parameters on the operation parameters adjustment interface, the user can input a display instruction according his/her requirements to determine the coordinate axes of the operation parameters which need to be displayed, and the present disclosure does not impose specific limitations on this. The user can input a display instruction to realize switching between different coordinate axes of the operation parameters.

For example, if the user inputs a display instruction for displaying the coordinate axes representing the air speed, the coordinate axes representing the air speed can be displayed on the operation parameters adjustment interface, as shown in Fig. 8. Among the coordinate axes representing the air speed, the horizontal axis represents different points in the historical time period, and the vertical axis represents the air speeds at different time points.

Before displaying the coordinate axes representing the air speed on the operation parameters adjustment interface, the air speeds of the air outlet device in the historical time period can be obtained; according to the air speeds in the historical time period, the first curve indicating the changes of the air speeds can be plotted in the coordinate system formed by the coordinate axes of the operation parameters. The first curve indicates the changes of the air speed in the historical time period. As shown in Fig. 8, the length of the historical time period is 30 minutes, and the thus the first curve in Fig. 8 represents the changes of the air speeds in the past 30 minutes.

After displaying the coordinate axes representing the air speeds, the user can perform sliding operations on the first curve in the coordinate system representing the air speed to modify the trajectory of the first curve. The modified first curve can represent the changes of the air speed in the future 30 minutes. When detecting an instruction for confirming the modification from the user, the first operation parameters in the future 30 minutes can be obtained according to the trajectory of the modified first curve.

The above procedure is the one for obtaining the air speeds. In addition to the air speeds, the operation parameters can include the angles indicating air flow direction and the like. Thus, when it is needed to obtain the angles indicating air flow direction, the above described procedure can be referred to, and thus the angles indicating air flow direction in a future time period can be obtained.

The second obtaining approach can include: displaying on the operation parameters adjustment interface coordinate axes of the operation parameters, among which a horizontal axis represents the time and a vertical axis represents the operation parameters; when detecting a sliding operation in a coordinate system formed by the coordinate axes of the operation parameters performed by the user, plotting in the coordinate system a second curve which indicates changes of the operation parameters in a future time period according to the sliding operation; and according to a trajectory of the second curve, obtaining the first operation parameters.

The operation parameters can be of different kinds, before displaying the coordinate axes of the operation parameters on the operation parameters adjustment interface, the user can input a display instruction according his/her requirements to determine the coordinate axes of the operation parameters which need to be displayed, and the present disclosure does not impose specific limitations on this. The user can input a display instruction to realize switching between different coordinate axes of the operation parameters.

After displaying the coordinate axes of the operation parameters on the operation parameters adjustment interface, the user can perform sliding operations in the coordinate system formed by the coordinate axes, and thus the terminal can plot the second curve in the coordinate system according to the sliding operation. The second curve can represent the changes of the operation parameters in a future time period. The first operation parameters in the future time period can be obtained according to the trajectory of the second curve.

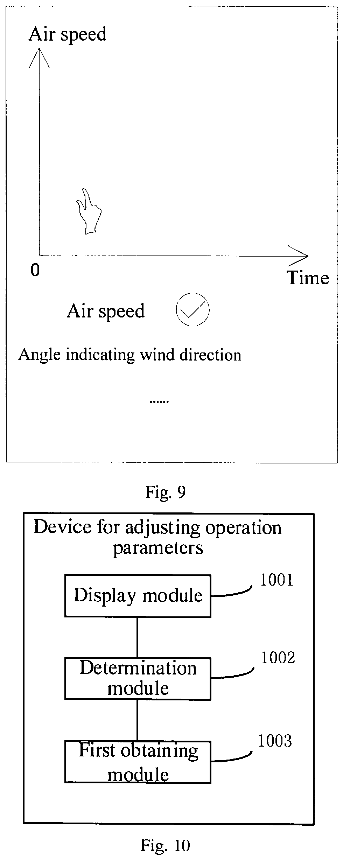

For example, if the user inputs a display instruction for displaying the coordinate axes representing the air speed, the coordinate axes representing the air speed can be displayed on the operation parameters adjustment interface, as shown in Fig. 9. Among the coordinate axes representing the air speed, the horizontal axis represents different points in the historical time period, and the vertical axis represents the air speeds at different time points.

After displaying the coordinate axes representing the air speeds, the user can perform sliding operations in the coordinate system representing the air speeds plot a second curve. For example, the length of the future time period is 30 minutes, and then the air speeds in the future 30 minutes can be obtained according to the trajectory of the second curve.

The above procedure is the one for obtaining the air speeds. In addition to the air speeds, the operation parameters can include the angles indicating air flow direction and the like. Thus, when it is needed to obtain the angles indicating air flow direction, the above described procedure can be referred to, and thus the angles indicating air flow direction in a future time period can be obtained.

It shall be noted that after obtaining the first operation parameters by any one of the above two obtaining approaches, the first operation parameters can be sent to the air outlet device to enable the air outlet device to output air according to the first operation parameters.

In the methods provided by examples of the present disclosure, by displaying an operation parameters adjustment interface, according to an operation on the operation parameters adjustment interface performed by a user, first operation parameters is obtained to enable the air outlet device to output air according to the first operation parameters. Users can adjust operation parameters on the operation parameters adjustment interface, and thus according to the adjusted operation parameters, the air outlet device can output air following the corresponding air outlet manners. Thus, there are provided diversified air outlet manners, and the air outlet device can output air according to users' demands. Consequently, better air outlet effects can be achieved when the operation parameters is adjusted.

Fig. 10 is a block diagram showing a device for adjusting operation parameters according to an exemplary embodiment. The device for adjusting operation parameters is a performed by a terminal. As shown in Fig. 10, the device includes a display module 1001, a determination module 1002 and a first obtaining module 1003.

The display module 1001 is configured to, when an instruction for displaying a theme pack list is detected, display the theme pack list on an application interface, wherein the theme pack list includes introductory information of at least one theme pack, and each theme pack contains operation parameters which is edited in advance.

The determination module 1002 is configured to, when a selection instruction on the theme pack list by a user is detected, determine a theme pack which is selected by the user according to the selection instruction.

The first obtaining module 1003 is configured to obtain the operation parameters in the selected theme pack to enable an air outlet device to output air according to the operation parameters, wherein the operation parameters includes at least an air speed and an angle indicating air flow direction.

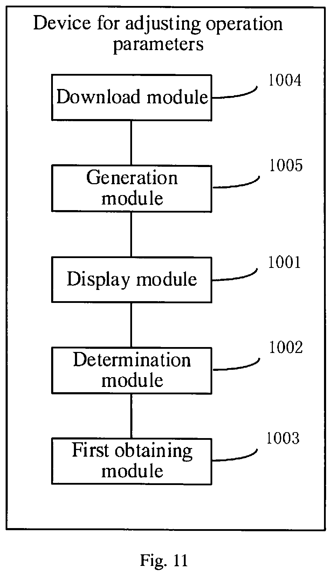

In the embodiment, as shown in Fig. 11, the device further includes a download module 1004 and a generation module 1005.

The download module 1004 is configured to download theme packs of different kinds and corresponding introductory information.

The generation module 1005 is configured to generate the theme pack list according to the introductory information of respective downloaded theme packs.

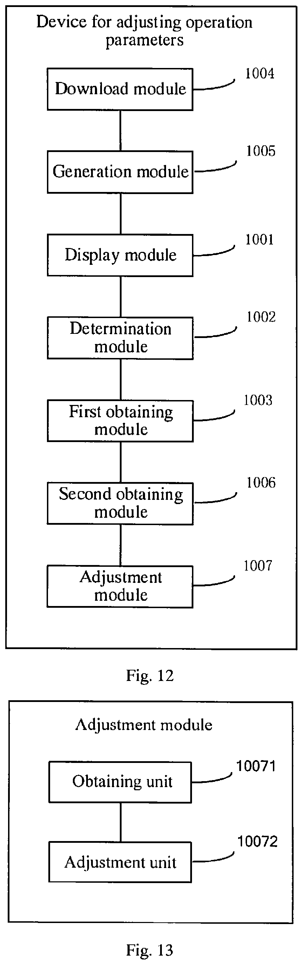

In the embodiment, as shown in Fig. 12, the device further includes a second obtaining module 1006 and an adjustment module 1007.

The second obtaining module 1006 is configured to obtain region information corresponding to the theme pack selected by the user.

The adjustment module 1007 is configured to, according to the region information, adjust an auxiliary device of the air outlet device, wherein the auxiliary device includes at least a temperature adjustment device.

In the embodiment, as shown in Fig. 13, the adjustment module 1007 includes an obtaining unit 10071 and an adjustment unit 10072.

The obtaining unit 10071 is configured to obtain current weather information of a region corresponding to the region information, wherein the weather information includes at least a temperature value.

The adjustment unit 10072 is configured to, according to the weather information, adjust the auxiliary device.

In the embodiment, when the auxiliary device is the temperature adjustment device, the adjustment unit 10072 is configured to send the temperature value in the weather information to the temperature adjustment device to enable the temperature adjustment device to adjust temperatures based on the temperature value, and when the auxiliary device is an oxygen generation device, the adjustment unit 10072 is configured to send an oxygen concentration value in the weather information to the oxygen generation device to enable the oxygen generation device to adjust oxygen concentrations based on the oxygen concentration value.

In the device provided by embodiments of the present invention, by displaying a theme pack list on an application interface, when detecting a selection instruction on the theme pack list by a user, a theme pack which is selected by the user is determined according to the selection instruction; and the operation parameters in the selected theme pack is obtained to enable an air outlet device to output air according to the operation parameters. Users can select theme packs of different kinds to make the air outlet device adjust the operation parameters according to the theme packs of different kinds, and then the air outlet device can output air following corresponding air outlet manners. Thus, there are provided diversified air outlet manners, and the air outlet device can output air according to users' demands. Consequently, better air outlet effects can be achieved when the operation parameters is adjusted.

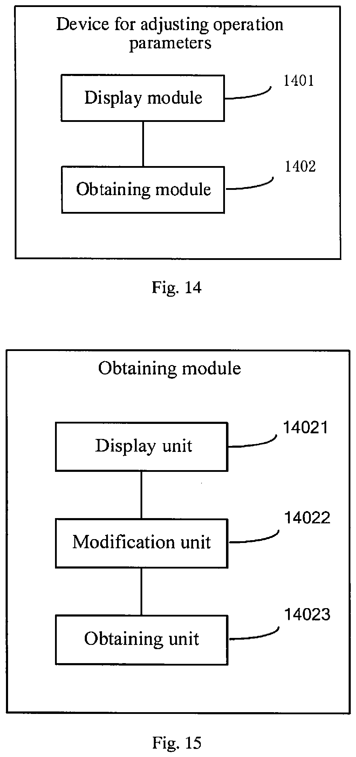

Fig. 14 is a block diagram showing a device for adjusting operation parameters according to an example of the present disclosure, which is not covered by the subject-matters of the claims. The device for adjusting operation parameters is performed by a terminal. As shown in Fig. 14, the device includes a display module 1401 and an obtaining module 1402.

The display module 1401 is configured to, when an instruction for adjusting operation parameters is detected, display an operation parameters adjustment interface which is configured to adjust an air speed and an angle indicating air flow direction of an air outlet device.

The obtaining module 1402 is configured to, according to an operation on the operation parameters adjustment interface performed by a user, obtain first operation parameters to enable the air outlet device to output air according to the first operation parameters.

In an example, as shown in Fig. 15, the obtaining module 1402 includes a display unit 14021, a modification unit 14022 and an obtaining unit 14023.

The display unit 14021 is configured to display on the operation parameters adjustment interface coordinate axes of the operation parameters, among which a horizontal axis represents the time and a vertical axis represents the operation parameters, wherein a first curve is plotted in a coordinate system formed by the coordinate axes of the operation parameters, and the first curve indicates changes of the operation parameters in a historical time period.

The modification unit 14022 is configured to, when a sliding operation on the first curve by the user is detected, modify a trajectory of the first curve according to the sliding operation.

The obtaining unit 14023 is configured to, according to the modified trajectory of the first curve, obtain the first operation parameters.

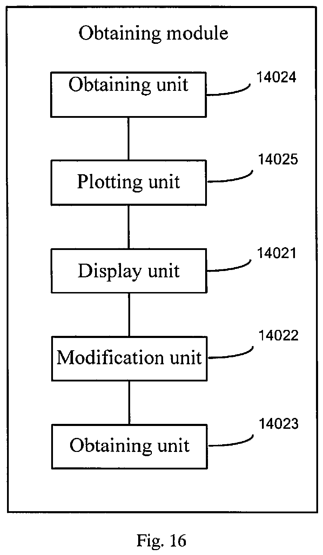

In an example, as shown in Fig. 16, the obtaining module further includes an obtaining unit 14024 and a plotting unit 14025.

The obtaining unit 14024 is configured to obtain operation parameters of the air outlet device in the historical time period.

The plotting unit 14025 is configured to, according to the operation parameters in the historical time period, plot the first curve indicating changes of the operation parameters in the coordinate system formed by the coordinate axes of the operation parameters.

In an example, the obtaining module 1402 is configured to: display on the operation parameters adjustment interface coordinate axes of the operation parameters, among which a horizontal axis represents the time and a vertical axis represents the operation parameters; when a sliding operation in a coordinate system formed by the coordinate axes of the operation parameters performed by the user is detected, plot in the coordinate system a second curve which indicates changes of the operation parameters in a future time period according to the sliding operation; and according to a trajectory of the second curve, obtain the first operation parameters.

In an example, the obtaining module 1402 is configured to: obtain second operation parameters indicating current operation status of the air outlet device; display the second operation parameters on the operation parameters adjustment interface; and when an operation for modifying the second operation parameters by the user is detected, obtain the first operation parameters which is resulted from modification of the second operation parameters.

In the device provided by examples of the present disclosure, by displaying an operation parameters adjustment interface, according to an operation on the operation parameters adjustment interface performed by a user, first operation parameters is obtained to enable the air outlet device to output air according to the first operation parameters. Users can adjust operation parameters on the operation parameters adjustment interface, and thus according to the adjusted operation parameters, the air outlet device can output air following the corresponding air outlet manners. Thus, there are provided diversified air outlet manners, and the air outlet device can output air according to users' demands. Consequently, better air outlet effects can be achieved when the operation parameters is adjusted.

With respect to the devices in the above embodiments and examples, the specific manners for performing operations for individual modules therein have been described in detail in the embodiments and examples regarding the methods, which will not be elaborated herein.

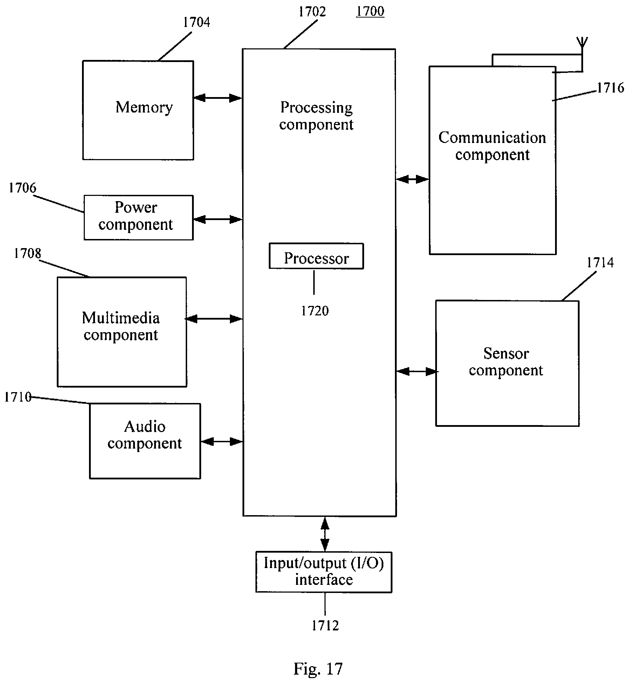

Fig. 17 is a block diagram showing a terminal 1700 according to an exemplary embodiment. For example, the terminal 1700 may be a mobile phone, a computer, a digital broadcast terminal, a messaging device, a gaming console, a tablet, a medical device, exercise equipment, a personal digital assistant, and the like.

Referring to Fig. 17, the electronic device 600 may include one or more of the following components: a processing component 1702, a memory 1704, a power component 1706, a multimedia component 1708, an audio component 1710, an input/output (I/O) interface 1712, a sensor component 1714, and a communication component 1716.

The processing component 1702 typically controls overall operations of the termianl 1700, such as the operations associated with display, telephone calls, data communications, camera operations, and recording operations. The processing component 1702 may include one or more processors 1720 to execute instructions to perform all or part of the steps in the above described methods. Moreover, the processing component 1702 may include one or more modules which facilitate the interaction between the processing component 1702 and other components. For instance, the processing component 1702 may include a multimedia module to facilitate the interaction between the multimedia component 1708 and the processing component 1702.

The memory 1704 is configured to store various types of data to support the operation of the terminal 1700. Examples of such data include instructions for any applications or methods operated on the terminal 1700, contact data, phonebook data, messages, pictures, video, etc. The memory 1704 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power component 1706 provides power to various components of the terminal 1700. The power component 1706 may include a power management system, one or more power sources, and any other components associated with the generation, management, and distribution of power in the terminal 1700.

The multimedia component 1708 includes a screen providing an output interface between the terminal 1700 and the user. In some embodiments, the screen may include a liquid crystal display (LCD) and a touch panel (TP). If the screen includes the touch panel, the screen may be implemented as a touch screen to receive input signals from the user. The touch panel includes one or more touch sensors to sense touches, swipes, and gestures on the touch panel. The touch sensors may not only sense a boundary of a touch or swipe action, but also sense a period of time and a pressure associated with the touch or swipe action. In some embodiments, the multimedia component 1708 includes a front camera and/or a rear camera. The front camera and the rear camera may receive an external multimedia datum while the terminal 1700 is in an operation mode, such as a photographing mode or a video mode. Each of the front camera and the rear camera may be a fixed optical lens system or have focus and optical zoom capability.

The audio component 1710 is configured to output and/or input audio signals. For example, the audio component 1710 includes a microphone ("MIC") configured to receive an external audio signal when the terminal 1700 is in an operation mode, such as a call mode, a recording mode, and a voice recognition mode. The received audio signal may be further stored in the memory 1704 or transmitted via the communication component 1716. In some embodiments, the audio component 1710 further includes a speaker to output audio signals.

The I/O interface 1712 provides an interface between the processing component 1702 and peripheral interface modules, such as a keyboard, a click wheel, buttons, and the like. The buttons may include, but are not limited to, a home button, a volume button, a starting button, and a locking button.

The sensor component 1714 includes one or more sensors to provide status assessments of various aspects of the terminal 1700. For instance, the sensor component 1714 may detect an open/closed status of the terminal 1700, relative positioning of components, e.g., the display and the keypad, of the terminal 1700, a change in position of the terminal 1700 or a component of the terminal 1700, a presence or absence of user contact with the terminal 1700, an orientation or an acceleration/deceleration of the terminal 1700, and a change in temperature of the terminal 1700. The sensor component 1714 may include a proximity sensor configured to detect the presence of nearby objects without any physical contact. The sensor component 1714 may also include a light sensor, such as a CMOS or CCD image sensor, for use in imaging applications. In some embodiments, the sensor component 1714 may also include an accelerometer sensor, a gyroscope sensor, a magnetic sensor, a pressure sensor, or a temperature sensor.

The communication component 1716 is configured to facilitate communication, wired or wirelessly, between the terminal 1700 and other devices. The terminal 1700 can access a wireless network based on a communication standard, such as WiFi, 2G, or 3G, or a combination thereof. In one exemplary embodiment, the communication component 1716 receives a broadcast signal or broadcast associated information from an external broadcast management system via a broadcast channel. In one exemplary embodiment, the communication component 1716 further includes a near field communication (NFC) module to facilitate short-range communications. For example, the NFC module may be implemented based on a radio frequency identification (RFID) technology, an infrared data association (IrDA) technology, an ultra-wideband (UWB) technology, a Bluetooth (BT) technology, and other technologies.

In exemplary embodiments, the terminal 1700 may be implemented with one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic components, for performing the method for adjusting operation data provided by any one of the embodiments and examples which are described in connection with Figs. 1, 2, 3 and 6.

Other embodiments of the invention will be apparent to those skilled in the art from consideration of the specification and practice of the invention disclosed here. This application is intended to cover any variations, uses, or adaptations of the invention following the general principles thereof and including such departures from the present invention as come within known or customary practice in the art. It is intended that the specification and examples be considered as exemplary only, with a true scope of the invention being indicated by the following claims.

It will be appreciated that the present invention is not limited to the exact construction that has been described above and illustrated in the accompanying drawings, and that various modifications and changes can be made without departing from the scope thereof. It is intended that the scope of the invention only be limited by the appended claims.

## Claims

1. A method for adjusting operation parameters of an air outlet device, comprising:
when detecting an instruction for displaying a theme pack list, displaying (101, 303) the theme pack list on an application interface, wherein the theme pack list comprises introductory information of at least one theme pack, and each theme pack contains operation parameters which are edited in advance;
when detecting a selection instruction on the theme pack list by a user, determining (102, 304) a theme pack which is selected by the user according to the selection instruction; and
obtaining (103,305) operation parameters in the selected theme pack to enable the air outlet device to output air according to the operation parameters, wherein the operation parameters comprises at least an air speed and an angle indicating air flow direction,
wherein before displaying (101, 303) the theme pack list on the application interface, the method further comprises:
downloading (301) theme packs of different kinds and corresponding introductory information; and
generating (302) the theme pack list according to the introductory information of respective downloaded theme packs;
wherein after determining the theme pack which is selected by the user according to the selection instruction when detecting the selection instruction on the theme pack list by the user, the method further comprises:
obtaining region information corresponding to the theme pack selected by the user; and
according to the region information, adjusting at least one auxiliary device of the air outlet device, wherein the at least one auxiliary device comprises at least a temperature adjustment device; and
wherein adjusting the at least one auxiliary device according to the region information, comprises:
obtaining current weather information of a region corresponding to the region information, wherein the weather information comprises at least a temperature value; and
according to the weather information, adjusting the at least one auxiliary device,
wherein adjusting the at least one auxiliary device of the air outlet device according to the region information, comprises:
sending the temperature value in the weather information to the temperature adjustment device to enable the temperature adjustment device to adjust temperatures based on the temperature value; and
when the at least one auxiliary device includes an oxygen generation device, sending an oxygen concentration value in the weather information to the oxygen generation device to enable the oxygen generation device to adjust oxygen concentrations based on the oxygen concentration value.

2. A device for adjusting operation parameters of an air outlet device, comprising:
a display module (1001) configured to, when an instruction for displaying a theme pack list is detected, display the theme pack list on an application interface, wherein the theme pack list comprises introductory information of at least one theme pack, and each theme pack contains operation parameters which is edited in advance;
a determination module (1002) configured to, when a selection instruction on the theme pack list by a user is detected, determine a theme pack which is selected by the user according to the selection instruction;
a first obtaining module (1003) configured to obtain operation parameters in the selected theme pack to enable the air outlet device to output air according to the operation parameters, wherein the operation parameters comprises at least an air speed and an angle indicating air flow direction;
a download module (1004) configured to download theme packs of different kinds and corresponding introductory information;
a generation module (1005) configured to generate the theme pack list according to the introductory information of respective downloaded theme packs;
a second obtaining module (1006) configured to obtain region information corresponding to the theme pack selected by the user; and
an adjustment module (1007) configured to, according to the region information, adjust at least one auxiliary device of the air outlet device, wherein the at least one auxiliary device comprises at least a temperature adjustment device;
wherein the adjustment module (1007) comprises:
an obtaining unit (10071) configured to obtain current weather information of a region corresponding to the region information, wherein the weather information comprises at least a temperature value; and
an adjustment unit (10072) configured to, according to the weather information, adjust the at least one auxiliary device,
wherein the adjustment unit (10072) is configured to send the temperature value in the weather information to the temperature adjustment device to enable the temperature adjustment device to adjust temperatures based on the temperature value, and when the at least one auxiliary device includes an oxygen generation device, the adjustment unit (10072) is configured to send an oxygen concentration value in the weather information to the oxygen generation device to enable the oxygen generation device to adjust oxygen concentrations based on the oxygen concentration value.

## Patentansprüche

1. Verfahren zum Einstellen von Betriebsparametern einer Luftauslassvorrichtung, umfassend:
beim Erkennen einer Anweisung zum Anzeigen einer Themenpaketliste Anzeigen (101, 303) der Themenpaketliste auf einer Anwendungsschnittstelle, wobei die Themenpaketliste Einführungsinformationen zu mindestens einem Themenpaket umfasst und jedes Themenpaket Betriebsparameter enthält, die im Voraus bearbeitet werden,
wenn ein Benutzer eine Auswahlanweisung auf der Themenpaketliste erkennt, Ermitteln (102, 304) eines Themenpakets, das von dem Benutzer gemäß der Auswahlanweisung ausgewählt wird, und
Erlangen (103, 305) von Betriebsparametern in dem ausgewählten Themenpaket, um es der Luftauslassvorrichtung zu ermöglichen, Luft gemäß den Betriebsparametern abzulassen, wobei die Betriebsparameter mindestens eine Luftgeschwindigkeit und einen Winkel, der eine Luftströmungsrichtung angibt, umfassen,
wobei das Verfahren vor dem Anzeigen (101, 303) der Themenpaketliste auf der Anwendungsschnittstelle ferner umfasst:
Herunterladen (301) von Themenpaketen verschiedener Art und entsprechenden Einführungsinformationen, und
Erzeugen (302) der Themenpaketliste gemäß den Einführungsinformationen jeweiliger heruntergeladener Themenpakete,
wobei das Verfahren nach Ermitteln des Themenpakets, das von dem Benutzer gemäß der Auswahlanweisung ausgewählt wird, wenn der Benutzer die Auswahlanweisung auf der Themenpaketliste erkennt, ferner umfasst:
Erlangen von regionalen Informationen, die dem Themenpaket entsprechen, das von dem Benutzer ausgewählt wird, und
Einstellen mindestens einer Zusatzvorrichtung der Luftauslassvorrichtung gemäß den regionalen Informationen, wobei die mindestens eine Zusatzvorrichtung mindestens eine Temperatureinstellvorrichtung umfasst, und
wobei das Einstellen der mindestens einen Zusatzvorrichtung gemäß den regionalen Informationen umfasst:
Erlangen aktueller Wetterinformationen einer Region, die den regionalen Informationen entsprechen, wobei die Wetterinformationen mindestens einen Temperaturwert umfassen, und
Einstellen der mindestens einen Zusatzvorrichtung gemäß den Wetterinformationen,
wobei das Einstellen der mindestens einen Zusatzvorrichtung der Luftauslassvorrichtung gemäß den regionalen Informationen umfasst:
Senden des Temperaturwerts in den Wetterinformationen an die Temperatureinstellvorrichtung, um es der Temperatureinstellvorrichtung zu ermöglichen, Temperaturen basierend auf dem Temperaturwert einzustellen, und
wenn die mindestens eine Zusatzvorrichtung eine Sauerstofferzeugungsvorrichtung beinhaltet, Senden eines Sauerstoffkonzentrationswerts in den Wetterinformationen an die Sauerstofferzeugungsvorrichtung, um es der Sauerstofferzeugungsvorrichtung zu ermöglichen, Sauerstoffkonzentrationen basierend auf dem Sauerstoffkonzentrationswert einzustellen.

2. Vorrichtung zum Einstellen von Betriebsparametern einer Luftauslassvorrichtung, umfassend:
ein Anzeigemodul (1001), das dazu ausgestaltet ist, beim Erkennen einer Anweisung zum Anzeigen einer Themenpaketliste die Themenpaketliste auf einer Anwendungsschnittstelle anzuzeigen, wobei die Themenpaketliste Einführungsinformationen zu mindestens einem Themenpaket umfasst und jedes Themenpaket Betriebsparameter enthält, die im Voraus bearbeitet werden,
ein Ermittlungsmodul (1002), das dazu ausgestaltet ist, wenn ein Benutzer eine Auswahlanweisung auf der Themenpaketliste erkennt, ein Themenpaket zu ermitteln, das von dem Benutzer gemäß der Auswahlanweisung ausgewählt wird,
ein erstes Erlangungsmodul (1003), das dazu ausgestaltet ist, Betriebsparameter in dem ausgewählten Themenpaket zu erlangen, um es der Luftauslassvorrichtung zu ermöglichen, Luft gemäß den Betriebsparametern abzulassen, wobei die Betriebsparameter mindestens eine Luftgeschwindigkeit und einen Winkel, der eine Luftströmungsrichtung angibt, umfassen,
ein Herunterlademodul (1004), das dazu ausgestaltet ist, Themenpakete verschiedener Art und entsprechende Einführungsinformationen herunterzuladen,
ein Erzeugungsmodul (1005), das dazu ausgestaltet ist, die Themenpaketliste gemäß den Einführungsinformationen jeweiliger heruntergeladener Themenpakete zu erzeugen,
ein zweites Erlangungsmodul (1006), das dazu ausgestaltet ist, regionale Informationen, die dem von dem Benutzer ausgewählten Themenpaket entsprechen, zu erlangen, und
ein Einstellmodul (1007), das dazu ausgestaltet ist, mindestens eine Zusatzvorrichtung der Luftauslassvorrichtung gemäß den regionalen Informationen einzustellen, wobei die mindestens eine Zusatzvorrichtung mindestens eine Temperatureinstellvorrichtung umfasst,
wobei das Einstellmodul (1007) umfasst:
eine Erlangungseinheit (10071), die dazu ausgestaltet ist, aktuelle Wetterinformationen einer Region, die den regionalen Informationen entsprechen, zu erlangen, wobei die Wetterinformationen mindestens einen Temperaturwert umfassen, und
eine Einstelleinheit (10072), die dazu ausgestaltet ist, die mindestens eine Zusatzvorrichtung gemäß den Wetterinformationen einzustellen,
wobei die Einstelleinheit (10072) dazu ausgestaltet ist, den Temperaturwert in den Wetterinformationen an die Temperatureinstellvorrichtung zu senden, um es der Temperatureinstellvorrichtung zu ermöglichen, Temperaturen basierend auf dem Temperaturwert einzustellen, und wenn die mindestens eine Zusatzvorrichtung eine Sauerstofferzeugungsvorrichtung beinhaltet, die Einstelleinheit (10072) dazu ausgestaltet ist, einen Sauerstoffkonzentrationswert in den Wetterinformationen an die Sauerstofferzeugungsvorrichtung zu senden, um es der Sauerstofferzeugungsvorrichtung zu ermöglichen, Sauerstoffkonzentrationen basierend auf dem Sauerstoffkonzentrationswert einzustellen.

## Revendications

1. Procédé de réglage de paramètres de fonctionnement d'un dispositif de sortie d'air,
lors de la détection d'une instruction pour afficher une liste d'ensembles thématiques, l'affichage (101, 303) de la liste d'ensembles thématiques sur une interface d'application, dans lequel la liste d'ensembles thématiques comprend des informations de base d'au moins un ensemble thématique, et chaque ensemble thématique contient des paramètres de fonctionnement qui sont édités à l'avance ;
lors de la détection d'une instruction de sélection sur la liste d'ensembles thématiques par un utilisateur, la détermination (102, 304) d'un ensemble thématique qui est sélectionné par l'utilisateur selon l'instruction de sélection ; et
l'obtention (103, 305) de paramètres de fonctionnement de l'ensemble thématique sélectionné, pour permettre au dispositif de sortie d'air d'émettre de l'air selon les paramètres de fonctionnement, dans lequel les paramètres de fonctionnement comprennent au moins une vitesse d'air et un angle indiquant une direction de flux d'air,
dans lequel, avant d'afficher (101, 303) la liste d'ensembles thématiques sur l'interface d'application, le procédé comprend en outre :
le téléchargement (301) d'ensembles thématiques de différents types et d'informations de base correspondantes ; et
la génération (302) de la liste d'ensembles thématiques selon les informations de base d'ensembles thématiques respectifs téléchargés ;
dans lequel, après avoir déterminé l'ensemble thématique qui est sélectionné par l'utilisateur selon l'instruction de sélection lors de la détection de l'instruction de sélection sur la liste d'ensembles thématiques par l'utilisateur, le procédé comprend en outre :
l'obtention d'informations de région correspondant à l'ensemble thématique sélectionné par l'utilisateur ; et
selon les informations de région, le réglage d'au moins un dispositif auxiliaire du dispositif de sortie d'air, dans lequel l'au moins un dispositif auxiliaire comprend au moins un dispositif de réglage de température ; et
dans lequel le réglage l'au moins un dispositif auxiliaire selon les informations de région, comprend :
l'obtention d'informations météorologiques actuelles d'une région correspondant aux informations de région, dans lequel les informations météorologiques comprennent au moins une valeur de température ; et
selon les informations météorologiques, le réglage de l'au moins un dispositif auxiliaire,
dans lequel le réglage de l'au moins un dispositif auxiliaire du dispositif de sortie d'air selon les informations de région, comprend :
l'envoi de la valeur de température dans les informations météorologiques au dispositif de réglage de température, pour permettre au dispositif de réglage de température de régler les températures sur la base de la valeur de température ; et
lorsque l'au moins un dispositif auxiliaire comporte un dispositif de génération d'oxygène, l'envoi d'une valeur de concentration d'oxygène dans les informations météorologiques au dispositif de génération d'oxygène, pour permettre au dispositif de génération d'oxygène de régler les concentrations d'oxygène sur la base de la valeur de concentration d'oxygène.

2. Dispositif pour le réglage paramètres de fonctionnement d'un dispositif de sortie d'air, comprenant :
un module d'affichage (1001) configuré pour, lorsqu'une instruction pour afficher une liste d'ensembles thématiques est détectée, afficher la liste d'ensembles thématiques sur une interface d'application, dans lequel la liste d'ensembles thématiques comprend des informations de base d'au moins un ensemble thématique, et chaque ensemble thématique contient des paramètres de fonctionnement qui sont édités à l'avance ;
un module de détermination (1002) configuré pour, lorsqu'une instruction de sélection sur la liste d'ensembles thématiques par un utilisateur est détectée, déterminer un ensemble thématique qui est sélectionné par l'utilisateur selon l'instruction de sélection ;
un premier module d'obtention (1003) configuré pour obtenir des paramètres de fonctionnement de l'ensemble thématique sélectionné, pour permettre au dispositif de sortie d'air d'émettre de l'air selon les paramètres de fonctionnement, dans lequel les paramètres de fonctionnement comprennent au moins une vitesse d'air et un angle indiquant une direction de flux d'air ;
un module de téléchargement (1004) configuré pour télécharger des ensembles thématiques de différents types et des informations de base correspondantes ;
un module de génération (1005) configuré pour générer la liste d'ensembles thématiques selon les informations de base d'ensembles thématiques respectifs téléchargés ;
un second module d'obtention (1006) configuré pour obtenir des informations de région correspondant à l'ensemble thématique sélectionné par l'utilisateur ; et
un module de réglage (1007) configuré pour régler au moins un dispositif auxiliaire du dispositif de sortie d'air selon les informations de région, dans lequel l'au moins un dispositif auxiliaire comprend au moins un dispositif de réglage de température ;
dans lequel le module de réglage (1007) comprend :
une unité d'obtention (10071) configurée pour obtenir des informations météorologiques actuelles d'une région correspondant aux informations de région, dans lequel les informations météorologiques comprennent au moins une valeur de température ; et
une unité de réglage (10072) configurée pour régler l'au moins un dispositif auxiliaire selon les informations météorologiques,
dans lequel l'unité de réglage (10072) est configurée pour envoyer la valeur de température dans les informations météorologiques au dispositif de réglage de température, pour permettre au dispositif de réglage de température de régler les températures sur la base de la valeur de température, et lorsque l'au moins un dispositif auxiliaire comporte un dispositif de génération d'oxygène, l'unité de réglage (10072) est configurée pour envoyer une valeur de concentration d'oxygène dans les informations météorologiques au dispositif de génération d'oxygène, pour permettre au dispositif de génération d'oxygène de régler les concentrations d'oxygène sur la base de la valeur de concentration d'oxygène.
